# EUROPÄISCHE PATENTANMELDUNG

(11) **EP 1 691 592 A1**
(43) Veröffentlichungstag der Anmeldung: **16.08.2006**
(21) Anmeldenummer: 06101200.1
(22) Anmeldetag: 02.02.2006
(51) Int. Cl.: H05K 1/18

(54) **Beleuchtungsvorrichtung**

(30) Priorität: 09.02.2005 DE 102005005896
(71) Anmelder: SIEMENS AKTIENGESELLSCHAFT, 80333 München (DE)
(72) Erfinder: Besch, Karl-Heinz, 82140 Olching (DE); Recktenwald, Dieter, 82166 Gräfelfing (DE); Schauer, Christian, 81371 München (DE)

(57) **Zusammenfassung**

Die Erfindung schafft eine Beleuchtungsvorrichtung, insbesondere zum Beleuchten von elektronischen Bauelementen und/oder von auf Bauelementeträgern aufgebrachten Markierungen, mit einer ersten Beleuchtungseinheit (111e), welche zumindest ein in einer ersten Beleuchtungsebene angeordnetes erstes Leuchtelement (120) aufweist, und einer zweiten Beleuchtungseinheit (111f), welche zumindest ein in einer zweiten Beleuchtungsebene angeordnetes zweites Leuchtelement (120) aufweist. Die Leuchtelemente sind (120) an einem gemeinsamen Schaltungsträger (110) angeordnet, welcher zumindest einen flächigen ersten starren Bereich (111e) und einen flächigen zweiten starren Bereich (111f) aufweist, wobei die beiden starren Bereiche (111e, 11f) über einen flexiblen Zwischenbereich (113e) des gemeinsamen Schaltungsträgers (110) winklig miteinander verbunden sind. Der erste starre Bereich (111e) stellt die erste Beleuchtungseinheit (111e) und der zweite starre Bereich (111f) stellt die zweite Beleuchtungseinheit (111f) dar, so dass ein Beleuchtungsfeld (135) unter verschiedenen Beleuchtungsrichtungen beleuchtbar ist. Die Erfindung ermöglicht eine Realisierung einer für eine Vielzahl von verschiedenen Beleuchtungssituationen einsetzbaren Beleuchtungsvorrichtung mittels einer einfachen Montagetätigkeit innerhalb einer kompakten Bauform.

## Beschreibung

Die Erfindung betrifft eine Vorrichtung zum Beleuchten von Objekten, insbesondere elektronische Bauelemente und/oder auf Bauelementeträgern aufgebrachten Markierungen, aus unterschiedlichen Richtungen.

Bei der automatischen Bestückung von Bauelementeträgern in so genannten Bestückautomaten werden Bauelemente von einer Bauelemente-Zuführeinrichtung an bestimmten Abholpositionen bereitgestellt. Dort werden sie von einem Bestückkopf abgeholt, welcher mittels eines Positioniersystems innerhalb eines Arbeitsbereiches frei positioniert werden kann. Die abgeholten Bauelemente werden von dem Bestückkopf zu einer Bestückposition transportiert und auf dem zu bestückenden Bauelementeträger an durch entsprechende Anschlussflächen definierten Einbaupositionen aufgesetzt.

Aufgrund der zunehmenden Miniaturisierung von elektronischen Bauelementen erfordert ein präziser Bestückvorgang eine genaue optische Lagevermessung der von dem Bestückkopf aufgenommenen Bauelemente. Ein präziser Bestückvorgang erfordert zusätzlich eine genaue Lagevermessung des zu bestückenden Bauelementeträgers, damit von dem Bestückkopf die richtigen Bestückpositionen mit hoher Genauigkeit angefahren werden können. Die Lagevermessung von Bauelementeträgern erfolgt üblicherweise anhand spezieller, an den jeweiligen Bauelementeträgern angebrachten Markierungen, welche von einer Beleuchtungsvorrichtung beleuchtet und von einer Kamera optisch erfasst werden.

Ein moderner Bestückautomat zeichnet sich jedoch nicht nur durch eine hohe Bestückgenauigkeit, sondern auch durch eine hohe Bestückleistung aus. Unter dem Begriff Bestückleistung ist in diesem Zusammenhang die maximale Anzahl an Bauelementen zu verstehen, die innerhalb einer bestimmten Zeiteinheit von der Bauelement-Zuführeinrichtung abgeholt und auf der Leiterplatte bzw. auf dem Bauelementeträger aufgesetzt werden können.

Um sowohl eine hohe Bestückgenauigkeit als auch eine hohe Bestückleistung zu erreichen, muss demzufolge die Positionsvermessung von Bauelement und Leiterplatte sowohl sehr präzise als auch sehr schnell erfolgen. Dafür ist neben einem hochwertigen Kamerasystem auch eine Beleuchtungsvorrichtung erforderlich, welche die zu erfassenden Objekte unter verschiedenen Beleuchtungswinkeln und/oder mit einem Licht mit unterschiedlichen Spektralanteilen mit möglichst hoher Lichtintensität beleuchtet. Bei Verwendung einer derart flexiblen Beleuchtungsvorrichtung können eine Vielzahl von verschiedenen Objekten mit unterschiedlichen optischen Eigenschaften zuverlässig von einem Kamerasystem erfasst und von einer nachgeschalteten Auswerteeinheit verarbeitet werden. Die Wahl von Beleuchtungswinkel bzw. Beleuchtungsspektrum hängt von dem optischen Verhalten des jeweils zu erfassenden Objekts und gegebenenfalls auch von dem optischen Verhalten des Hintergrundes ab, vor dem das jeweilige Objekt aufgenommen wird.

Aus der DE 10128476 C2 ist eine optische Sensorvorrichtung bekannt, bei der drei unterschiedliche Beleuchtungseinheiten vorgesehen sind, welche das zu erfassende Objekt jeweils aus einem unterschiedlichen Winkel beleuchten. Einige der Beleuchtungseinheiten weisen zumindest zwei in voneinander unterschiedlichen Spektralbereichen emittierende Leuchtelemente auf. Sämtliche Leuchtelemente sind mittels einer Steuervorrichtung unabhängig voneinander ansteuerbar, so dass das Beleuchtungsspektrum jeweils optimal auf die jeweils erforderlichen Lichtverhältnisse angepasst werden kann. Die optische Sensorvorrichtung hat jedoch den Nachteil, dass die die drei Beleuchtungseinheiten aufweisende Beleuchtungsvorrichtung nur auf aufwendige Art und Weise hergestellt werden kann, da die entsprechenden Leuchtelemente an unterschiedlichen Positionen in unterschiedlichen Beleuchtungsebenen innerhalb der Beleuchtungsvorrichtung angebracht werden müssen.

Der Erfindung liegt die Aufgabe zugrunde, eine Beleuchtungsvorrichtung zu schaffen, welche eine Beleuchtung eines Objektes aus unterschiedlichen Richtungen ermöglicht und mittels einer einfachen Montagetätigkeit hergestellt werden kann.

Diese Aufgabe wird gelöst durch eine Beleuchtungsvorrichtung, insbesondere zum Beleuchten von elektronischen Bauelementen und/oder von auf Bauelementeträgern aufgebrachten Markierungen, mit den Merkmalen des unabhängigen Anspruchs 1.

Die erfindungsgemäße Beleuchtungsvorrichtung umfasst eine erste Beleuchtungseinheit, welche zumindest ein in einer ersten Beleuchtungsebene angeordnetes erstes Leuchtelement aufweist, und eine zweite Beleuchtungseinheit, welche zumindest ein in einer zweiten Beleuchtungsebene angeordnetes zweites Leuchtelement aufweist. Gemäß der Erfindung sind die Leuchtelemente an einem gemeinsamen Schaltungsträger angeordnet, welcher zumindest einen flächigen ersten starren Bereich und einen flächigen zweiten starren Bereich aufweist, wobei die beiden starren Bereiche über einen flexiblen Zwischenbereich des gemeinsamen Schaltungsträgers winklig miteinander verbunden sind. Der erste starre Bereich stellt gemäß der Erfindung die erste Beleuchtungsebene und der zweite starre Bereich die zweite Beleuchtungsebene dar, so dass ein Beleuchtungsfeld unter verschiedenen Beleuchtungsrichtungen beleuchtet werden kann.

Der Erfindung liegt die Erkenntnis zugrunde, dass der mechanische Aufbau einer Beleuchtungsvorrichtung durch Verwendung einer in so genannter Starr-Flex-Technik gefertigten Platine bzw. Leiterplatte, auf welcher möglichst sämtliche Leuchtelemente der Beleuchtungsvorrichtung angebracht sind, erheblich vereinfacht werden kann. Auf diese Weise ist nicht mehr eine Vielzahl von Einzelplatinen zur Realisierung einer Vielzahl von unterschiedlichen Beleuchtungsebenen notwendig. Dies ermöglicht einen Aufbau der erfindungsgemäßen Beleuchtungsvorrichtung mittels einer einfachen Montagetätigkeit innerhalb einer kompakten Bauform. Damit kann auf vorteilhafte Weise auf eine verschachtelte Anordnung von Leuchtelementen und Spiegelschächten verzichtet werden, welche bei herkömmlichen kompakt aufgebauten Beleuchtungsvorrichtungen erforderlich sind, um Objekte unter unterschiedlichen Winkeln zu beleuchten.

Die erfindungsgemäße Beleuchtungsvorrichtung kann auf einfache Weise insbesondere dann hergestellt werden, wenn die Leuchtelemente so genannte SMD (Surface Mount Device) - Bauelemente sind. Als Leuchtelemente eignen sich demzufolge insbesondere Leuchtdioden, welche preiswert sind und bei geringem Strombedarf eine hohe Lichtausbeute liefern.

Gemäß Anspruch 2 weist zumindest eine der beiden Beleuchtungseinheiten zwei Leuchtelemente auf. Somit kann das Beleuchtungsfeld auf einfache Weise bei einer homogenen Lichtstärkenverteilung mit intensivem Beleuchtungslicht erhellt werden, wobei die Homogenität und die Lichtintensität mit der Anzahl an Leuchtelementen stetig zunimmt, die einer Beleuchtungseinheit zugeordnet sind. Im Prinzip gibt es für die Anzahl der Leuchtelemente keine Obergrenze, so dass bevorzugt möglichst viele Leuchtelemente für eine Beleuchtungseinheit verwendet werden sollten. In der Praxis ist die Anzahl der Leuchtelemente lediglich durch den erforderlichen Platzbedarf bzw. durch eine Erwärmung begrenzt, welche bei einem entsprechenden Stromfluss durch jedes einzelne Leuchtelement erzeugt wird.

Gemäß Anspruch 3 sind die Leuchtelemente derart eingerichtet, dass sie Beleuchtungslicht in unterschiedlichen Spektralbereichen emittieren können. Durch eine entsprechende Ansteuerung der jeweiligen Beleuchtungseinheiten kann somit das Beleuchtungslicht auf eine Vielzahl von verschiedenen Situationen optimal angepasst werden, welche durch das optische Verhalten der zu erfassenden Objekte und ggf. des jeweiligen Hintergrundes bestimmt sind. Die unterschiedlichen Spektralbereiche können entweder dadurch realisiert werden, dass unterschiedliche Leuchtelemente unterschiedliche Spektralverteilungen am Beleuchtungslicht emittieren oder dass ein Leuchtelement verschiedene Spektralbereiche abdeckt.

Gemäß Anspruch 4 ist der Zwischenbereich eine in dem gemeinsamen Schaltungsträger ausgebildete Nut. Dabei ist unter dem Begriff Nut jede Art von länglichem Bereich zu verstehen, in dem die Dicke des Schaltungsträgers derart reduziert ist, dass der Schaltungsträger an dieser Stelle eine Flexibilität aufweist. Eine Nut kann auch dann ausgebildet sein, wenn quer zu dem länglichen Zwischenbereich Leiterbahnen verlaufen, welche beispielsweise zur Kontaktierung von auf einem benachbarten starren Bereich angebrachten Leuchtelementen vorgesehen ist.

Durch eine längliche Nut sind somit zwei starre Bereiche des Schaltungsträgers derart zueinander angeordnet, dass sie zwei zueinander parallele Kanten aufweisen. Somit ist der gemeinsame Schaltungsträger ein flexibler Körper, bei dem jeweils zwei starre Bereiche durch einen scharnierartigen Zwischenbereich miteinander verbunden sind.

Gemäß Anspruch 5 weist der gemeinsame Schaltungsträger zumindest drei über zumindest zwei flexible Zwischenbereiche miteinander verbundene starre Bereiche auf, welche um eine optische Achse herum angeordnet sind. Auf diese Weise kann eine quasi geschlossene Anordnung aufgebaut werden, welche eine Beleuchtung des Beleuchtungsfeldes aus allen möglichen Azimutwinkeln ermöglicht. Das Beleuchtungsfeld ist dabei an einem Ende der optischen Achse angeordnet und senkrecht zu der optischen Achse orientiert. Dies bedeutet, dass die Beleuchtungsvorrichtung eine Beleuchtung aus unterschiedlichen Richtungen ermöglicht, wobei die unterschiedlichen Richtungen relativ zu der optischen Achse den gleichen Beleuchtungswinkel aufweisen.

Eine quasi geschlossene Anordnung erreicht man dann, wenn die Anzahl der flexiblen Bereiche um eins kleiner ist als die Anzahl der starren Bereiche. Selbstverständlich kann die Beleuchtungsvorrichtung auch mit einem gemeinsamen Schaltungsträger realisiert werden, bei dem die Anzahl der Zwischenbereiche und die Anzahl der starren Bereiche gleich ist. In diesem Fall erhält man nicht nur eine quasi geschlossene, sondern eine real geschlossene Anordnung von unterschiedlichen Beleuchtungsebenen.

Bevorzugt weist die Beleuchtungsvorrichtung acht starre Bereiche auf, die über sieben Zwischenbereiche miteinander verbunden sind und demzufolge ein quasi geschlossenes Achteck bilden. Eine derartige Beleuchtungsvorrichtung hat sich als besonders leistungsfähig erwiesen, da mit einem überschaubaren mechanischen Aufwand eine Vielzahl von verschiedenen Beleuchtungswinkeln und damit eine weitgehend isotrope Beleuchtung realisiert werden kann.

Gemäß Anspruch 6 weist der gemeinsame Schaltungsträger zumindest einen weiteren starren Bereich auf, welcher über einen weiteren flexiblen Zwischenbereich des gemeinsamen Schaltungsträgers winklig mit einem der starren Bereiche miteinander verbunden ist. Die Beleuchtungsvorrichtung ermöglicht damit nicht nur eine Beleuchtung mit unterschiedlichen Azimut-, sondern auch mit unterschiedlichen Neigungswinkeln relativ zur optischen Achse, wobei die unterschiedlichen Neigungswinkel auf einer unterschiedlichen Orientierung der starren Bereiche und der weiteren starren Bereiche relativ zu der optischen Achse beruhen. Bevorzugt ist jedem starren Bereich ein weiterer starrer Bereich nebengeordnet, so dass bei der bevorzugten Ausführungsform mit acht starren Bereichen insgesamt sechzehn Beleuchtungsebenen vorhanden sind, welche das Beleuchtungsfeld aus insgesamt sechzehn verschiedenen Richtungen beleuchten. Alternativ können die weiteren starren Bereiche auch untereinander über jeweils einen flexiblen Zwischenbereich miteinander verbunden sein, so dass der Schaltungsträger eine Anordnung aus starren Bereichen und eine weitere Anordnung aus weiteren starren Bereichen aufweist, wobei die beiden Anordnungen bevorzugt über lediglich einen einzigen weiteren flexiblen Zwischenbereich miteinander verbunden sind.

Gemäß Anspruch 7 weist die Beleuchtungsvorrichtung einen gemeinsamen elektrischen Anschluss auf, welcher mit sämtlichen Leuchtelementen elektrisch gekoppelt ist. Somit ist auf vorteilhafte Weise zur Ansteuerung einer Vielzahl von Leuchtelementen nicht eine Vielzahl von Steckverbindungen erforderlich, so dass die gesamte Beleuchtungsvorrichtung über einen gemeinsamen Anschluss mit Strom versorgt werden kann. Der Einbau von teuren und Bauraum konsumierenden Steckverbindungen kann somit minimiert werden.

Der gemeinsame Anschluss kann eine Vielzahl von elektrischen Verbindungsleitungen aufweisen, so dass unterschiedliche Leuchtelemente individuell angesteuert werden können. Die Ansteuerung der Leuchtelemente kann jedoch auch über einen gemeinsamen Anschluss erfolgen, welcher neben einer zentralen Stromversorgung eine Datenleitung aufweist, über die eine Vielzahl von verschiedenen Beleuchtungssituationen übertragen und die entsprechenden Leuchtelemente aktiviert werden können.

Gemäß Anspruch 8 ist eine elektronische Treiberschaltung zum Ansteuern der Leuchtelemente ebenfalls an dem gemeinsamen Schaltungsträger angebracht. Dies hat den Vorteil, dass alle für die Beleuchtungsvorrichtung erforderlichen elektronischen und optoelektronischen Bauelemente auf dem gemeinsamen Schaltungsträger angeordnet sind und somit auch für die elektronische Ansteuerung der unterschiedlichen Beleuchtungseinheiten keine zusätzliche Leiterplatte erforderlich ist.

Gemäß Anspruch 9 ist der gemeinsame Schaltungsträger mit Befestigungselementen versehen, welche zum Fixieren des Schaltungsträgers an einem Gehäuse der Beleuchtungsvorrichtung ausgebildet sind. Somit können auf einfache Weise die Winkellagen der starren Bereiche festgelegt werden, so dass der mechanische Aufbau der Beleuchtungsvorrichtung eine hohe Stabilität aufweist. Im einfachsten Fall sind die Befestigungselemente jeweils eine Aussparung bzw. ein Loch in einem oder in mehreren der starren oder in einem oder in mehreren der weiteren starren Bereiche.

Weitere Vorteile und Merkmale der vorliegenden Erfindung ergeben sich aus der folgenden beispielhaften Beschreibung einer derzeit bevorzugten Ausführungsform.

In der Zeichnung zeigen
- Figur 1: eine Beleuchtungsvorrichtung mit einem in Form eines Achtecks ausgebildeten gemeinsamen Schaltungsträger und
- Figur 2: eine Schnittdarstellung der in Figur 1 dargestellten Beleuchtungsvorrichtung.

An dieser Stelle bleibt anzumerken, dass sich in der Zeichnung die Bezugszeichen einander entsprechender Komponenten lediglich in ihrer ersten Ziffer unterscheiden.

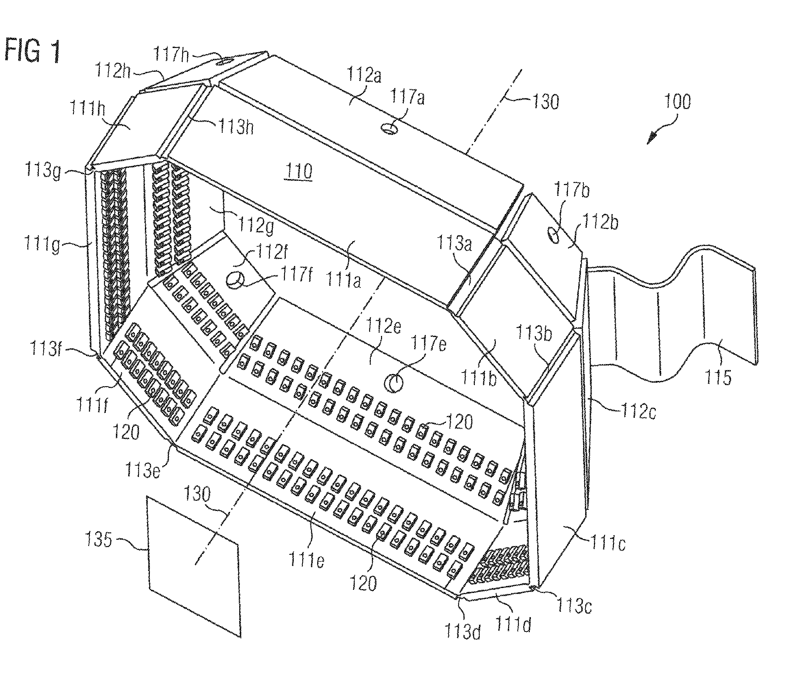

Figur 1 zeigt eine Beleuchtungsvorrichtung 100, welche einen Schaltungsträger 110 aufweist, an dem eine Vielzahl von unterschiedlichen Leuchtdioden 120 angebracht sind. Der Schaltungsträger 110 weist eine achteckige Form auf, wobei acht starre Bereiche 111a, 111b, 111c, 111d, 111e, 111f, 111g und 111h über insgesamt sieben flexible Zwischenbereiche 113a, 113b, 113c, 113d, 113e, 113f und 113g verbunden sind. Jeweils zwei benachbarte starre Bereiche 111 sind derart winklig zueinander angeordnet, dass die recht Kante des starren Bereichs 111h zumindest annähernd neben der linken Kante des starren Bereichs 111a angeordnet ist. Somit bilden die starren Bereiche 111a des Schaltungsträgers 110 ein quasi geschlossenes Achteck, welches um eine optische Achse 130 herum symmetrisch angeordnet ist. Auf der optischen Achse 130 liegt auch ein Beleuchtungsfeld 135, welches durch die Beleuchtungsvorrichtung 100 mit einer weitgehend homogenen Beleuchtungsstärke aus unterschiedlichen Beleuchtungswinkeln beleuchtet wird.

An jedem der starren Bereiche 111 ist über jeweils einen weiteren flexiblen Zwischenbereich ein weiterer starrer Bereich 112 angeordnet, wobei ein starrer Bereich 111 und ein zugeordneter weiterer starrer Bereich 112 in einer unterschiedlichen Winkellage relativ zu der optischen Achse 130 orientiert sind. An den weiteren starren Bereichen 112 sind jeweils ebenso eine Mehrzahl von Leuchtdioden 120 angeordnet, so dass das Beleuchtungsfeld 135 nicht nur aus unterschiedlichen Azimutwinkeln, sondern auch aus gegenüber der optischen Achse 130 unterschiedlichen Neigungswinkeln beleuchtet wird.

Die starren Bereiche 111 weisen gemäß dem hier dargestellten Ausführungsbeispiel jeweils die Form eines Rechtecks auf. Um ein Einklappen der weiteren starren Bereiche 112 relativ zu den starren Bereichen 111 in Richtung der optischen Achse 130 zu ermöglichen, haben die weiteren starren Bereiche 112 die Form eines Trapezes. Dabei grenzt die längere Trapez-Unterseite an den jeweils benachbarten starren Bereich 111 an.

Es wird darauf hingewiesen, dass selbstverständlich auch die starren Bereiche 111 eine derartige Trapezform aufweisen können, dass die über die flexiblen Zwischenbereiche 113 miteinander verbundenen starren Bereiche 111 bereits schrägt zu der optischen Achse 130 angeordnet sind.

Um eine stabile Halterung der Beleuchtungsvorrichtung 100 in einem nicht dargestellten Gehäuse auf einfache Weise zu ermöglichen, sind in einigen der weiteren starren Bereiche 112 des gemeinsamen Schaltungsträgers 110 Löcher 117 ausgebildet, von denen in Figur 1 lediglich die Löcher 117a, 117b, 117e, 117f und 117h zu erkennen sind. Mittels dieser Löcher 117 können die weiteren starren Bereiche 112 in einer festen Winkellage relativ zu der optischen Achse 130 in dem nicht dargestellten Gehäuse stabil befestigt werden. Die Beleuchtungsvorrichtung 100 weist ferner eine Halterung 115 auf, welche ebenfalls der räumlichen Fixierung des gemeinsamen Schaltungsträgers 110 in dem Gehäuse dient.

Die winklige Anordnung des Schaltungsträgers 110 in Form eines Achtecks mit starren Bereichen 111, welche in einem ersten Neigungswinkel relativ zu der optischen Achse 130 angeordnet sind, und mit weiteren starren Bereichen 112, welche in einem zweiten von dem ersten Neigungswinkel unterschiedlichen Neigungswinkel relativ zu der optischen Achse 130 angeordnet sind, hat den Vorteil, dass die Beleuchtungsvorrichtung 100 in einer kompakten Bauform realisiert und mittels einer einfachen Montagetätigkeit aufgebaut werden kann. Durch die unmittelbare Beleuchtung des Beleuchtungsfeldes 135 durch eine Vielzahl von verschiedenen Leuchtdioden 120 kann auf Spiegel und sonstige optische Elemente verzichtet werden und trotzdem unter verschiedenen Beleuchtungswinkeln eine sowohl homogene als auch intensive Beleuchtung realisiert werden.

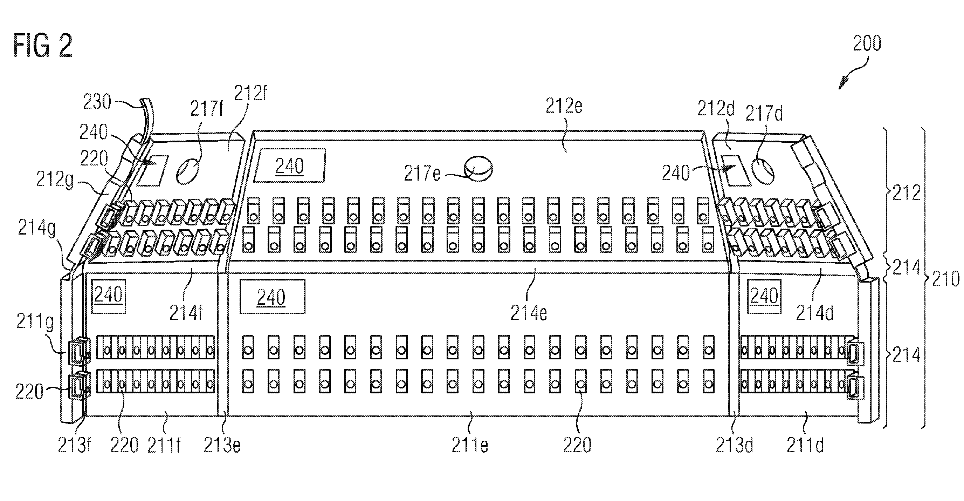

Figur 2 zeigt die Beleuchtungsvorrichtung 100, die nunmehr mit dem Bezugszeichen 200 gekennzeichnet ist, in einer Schnittansicht. In dieser Schnittansicht sind von dem gemeinsamen Schaltungsträger 210 lediglich die starren Bereiche 211d, 211e, 211f und 211g zu erkennen, welche über flexible Zwischenbereiche 213 miteinander verbunden sind. Von den flexiblen Zwischenbereichen 213 sind in Figur 2 lediglich die flexiblen Zwischenbereiche 213d und 213e deutlich und der flexible Zwischenbereich 213f nur bei genauer Betrachtung zu erkennen. Die starren Bereiche 211 sind mit den weiteren starren Bereichen 212 über die weiteren flexiblen Zwischenbereiche 214 verbunden, wobei lediglich die weiteren starren Bereiche 212d, 212e, 212f und 212g sowie die weiteren flexiblen Zwischenbereiche 214d. 214e, 214f und 214g zu erkennen sind. Ebenfalls zu erkennen sind die Befestigungslöcher 217d, 217e bzw. 217f, welche in den weiteren starren Bereichen 212d, 212e bzw. 212f ausgebildet sind.

Sämtliche Leuchtdioden 220 werden über einen zentralen Anschluss 230 mit elektrischem Strom versorgt, so dass auf vorteilhafte Weise die Beleuchtungsvorrichtung 200 mit lediglich einem einzigen Anschlusskabel betrieben werden kann. Die elektrische Kontaktierung der Leuchtdioden 220 ist zusätzlich durch insgesamt sechzehn Treiberschaltungen 240 vereinfacht, wobei jeweils eine Treiberschaltung auf einem starren bzw. weiteren starren Bereich ausgebildet ist. Verbindungsstrukturen (Leiterbahnen) zwischen dem zentralen Anschluss 230 und den Treiberschaltungen 240 und zwischen den Treiberschaltungen 240 und den Leuchtdioden 220 sind in Figur 2 nicht dargestellt.

Selbstverständlich können auch zwei oder mehrere an unterschiedlichen starren Bereichen ausgebildete Treiberschaltungen 240 zusammengefasst werden. Die Ausbildung der Treiberschaltungen auf dem gemeinsamen Schaltungsträger 210 hat den Vorteil, dass der zentrale Anschluss 230 lediglich eine Stromversorgung und eine oder mehrere Datenleitungen umfassen muss, wobei trotzdem eine individuelle Ansteuerbarkeit der unterschiedlichen Leuchtdioden möglich ist. Eine derartige individuelle Ansteuerbarkeit hat den Vorteil, dass für eine Vermessung eines Objekts durch eine ebenfalls auf der optischen Achse 130 angeordnete und in Figur 2 nicht dargestellte Kamera die Beleuchtung hinsichtlich der Intensität, der spektralen Verteilung und den Beleuchtungsrichtungen optimal an die jeweils erforderliche Beleuchtungssituation angepasst werden kann.

### Bezugszeichenliste

- 100: Beleuchtungsvorrichtung
- 110: Schaltungsträger
- 111: starre Bereiche
- 111a/b/c/d/e/f/g/h: starrer Bereich
- 112: weitere starre Bereiche
- 112a/b/c/d/e/f/g/h: weiterer starrer Bereich
- 113: flexible Zwischenbereiche
- 113a/b/c/d/e/f/g/h: flexibler Zwischenbereich
- 115: Halterung
- 117: Löcher
- 117a/b/e/f/h: Loch
- 120: LED
- 130: optische Achse
- 135: Beleuchtungsfeld

- 200: Beleuchtungsvorrichtung
- 210: Schaltungsträger
- 211: starre Bereiche
- 211d/e/f/g: starrer Bereich
- 212: weitere starre Bereiche
- 212d/e/f/g: weiterer starrer Bereich
- 213: flexible Zwischenbereiche
- 213d/e/f: flexibler Zwischenbereich
- 214: weitere flexible Zwischenbereiche
- 214d/e/f/g: weiterer flexibler Zwischenbereich
- 217d/e/f: Loch
- 220: LED
- 230: zentraler Anschluss
- 240: Treiberschaltung

## Patentansprüche

1. Beleuchtungsvorrichtung, insbesondere zum Beleuchten von elektronischen Bauelementen und/oder von auf Bauelementeträgern aufgebrachten Markierungen, mit
• einer ersten Beleuchtungseinheit (111e), welche zumindest ein in einer ersten Beleuchtungsebene angeordnetes erstes Leuchtelement (120) aufweist, und
• einer zweiten Beleuchtungseinheit (111f), welche zumindest ein in einer zweiten Beleuchtungsebene angeordnetes zweites Leuchtelement (120) aufweist,
wobei
- die Leuchtelemente (120) an einem gemeinsamen Schaltungsträger (110) angeordnet sind, welcher zumindest einen flächigen ersten starren Bereich (111e) und einen flächigen zweiten starren Bereich (111f) aufweist, welche über einen flexiblen Zwischenbereich (113e) des gemeinsamen Schaltungsträgers (110) winklig miteinander verbunden sind, und
- der erste starre Bereich (111e) die erste Beleuchtungseinheit (111e) und der zweite starre Bereich (111f) die zweite Beleuchtungseinheit (111f) darstellt, so dass ein Beleuchtungsfeld (135) unter verschiedenen Beleuchtungsrichtungen beleuchtbar ist.

2. Beleuchtungsvorrichtung nach Anspruch 1, bei der zumindest eine Beleuchtungseinheit (111) zumindest zwei Leuchtelemente (120) aufweist.

3. Vorrichtung nach einem der Ansprüche 1 bis 2, bei der die Leuchtelemente (120) eingerichtet sind zum Aussenden von Beleuchtungslicht in unterschiedlichen Spektralbereichen.

4. Beleuchtungsvorrichtung nach einem der Ansprüche 1 bis 3, bei der der Zwischenbereich (113) eine in dem gemeinsamen Schaltungsträger ausgebildete Nut ist.

5. Beleuchtungsvorrichtung nach einem der Ansprüche 1 bis 4, bei der der gemeinsame Schaltungsträger (110) zumindest drei über flexible Zwischenbereiche (113) miteinander verbundene starre Bereiche (111) aufweist, welche um eine optische Achse (130) herum angeordnet sind.

6. Beleuchtungsvorrichtung nach Anspruch 5, bei der der gemeinsame Schaltungsträger (210) zumindest einen weiteren starren Bereich (212e) aufweist, welcher über einen weiteren flexiblen Zwischenbereich (214e) des gemeinsamen Schaltungsträgers (210) winklig mit einem der starren Bereiche (211e) miteinander verbunden ist.

7. Beleuchtungsvorrichtung nach einem der Ansprüche 1 bis 6, zusätzlich mit einem elektrischen Anschluss (230), welcher mit einer Vielzahl von Leuchtelementen (220) elektrisch gekoppelt ist.

8. Vorrichtung nach einem der Ansprüche 1 bis 7, zusätzlich mit einer elektronischen Treiberschaltung (240) zum Ansteuern der Leuchtelemente (220), wobei die Treiberschaltung (240) ebenfalls an dem gemeinsamen Schaltungsträger (210) angebracht ist.

9. Vorrichtung nach einem der Ansprüche 1 bis 8, bei der der gemeinsame Schaltungsträger (110) mit Befestigungselementen (117, 115) versehen ist, welche zum Fixieren des gemeinsamen Schaltungsträgers (110) an einem Gehäuse ausgebildet sind.
